# EUROPÄISCHE PATENTSCHRIFT

(11) **EP 2 628 193 B1**
(45) Veröffentlichungstag und Bekanntmachung des Hinweises auf die Patenterteilung: **08.08.2018**
(21) Anmeldenummer: 11767020.8
(22) Anmeldetag: 10.10.2011
(51) Int. Cl.: H01L 33/44, H01L 33/50, H01L 33/46

(54) **KONVERSIONSBAUTEIL**
CONVERSION COMPONENT
COMPOSANT DE CONVERSION

(30) Priorität: 11.10.2010 DE 102010048162
(43) Veröffentlichungstag der Anmeldung: 21.08.2013
(73) Patentinhaber: OSRAM Opto Semiconductors GmbH, 93055 Regensburg (DE)
(72) Erfinder: AHLSTEDT, Mikael, 80686 München (DE); LIEPOLD, Ute, 80939 München (DE); SCHUH, Carsten, 85598 Baldham (DE); PHAM-GIA, Khanh, 85579 Neubiberg (DE)
(74) Vertreter: Epping - Hermann - Fischer
(86) Internationale Anmeldenummer: PCT/EP2011/067658
(87) Internationale Veröffentlichungsnummer: WO 2012/049129

(56) Entgegenhaltungen:
- EP-A1- 2 216 834
- WO-A1-2008/056292
- WO-A1-2010/106478
- WO-A2-2012/038483
- DE-A1-102004 053 116
- JP-A- 2010 157 638

## Beschreibung

Es wird ein Konversionsbauteil sowie ein Halbleiterbauelement mit einem solchen Konversionsbauteil angegeben.

WO 2008/056292 A1, WO 2012/038483 A2 und JP 2010 157638 A offenbaren Halbleiterbauelemente mit Konversionsbauteilen. Eine zu lösende Aufgabe besteht darin, ein Konversionsbauteil anzugeben, welches verbesserte Konversionseigenschaften aufweist.
Gemäß zumindest einer Ausführungsform ist das Konversionsbauteil zum Nachordnen an einer Strahlungsauskoppelfläche eines strahlungsemittierenden Halbleiterchips geeignet. Zum Beispiel ist das Konversionsbauteil in einem Halbleiterbauelement verbaubar. Beispielsweise umfasst ein solches Halbleiterbauelement den strahlungsemittierenden Halbleiterchip. Das Konversionsbauteil kann dem strahlungsemittierenden Halbleiterchip in seiner Hauptabstrahlrichtung an der Strahlungsauskoppelfläche nachgeordnet sein. Vorzugsweise konvertiert das Konversionsbauteil von vom Halbleiterchip emittierte elektromagnetische Strahlung eines Wellenlängebereichs in elektromagnetische Strahlung eines anderen Wellenlängenbereichs.
Gemäß zumindest einer Ausführungsform des Konversionsbauteils umfasst dieses ein Konverterelement, das eine erste Hauptfläche, eine der ersten Hauptfläche gegenüberliegende zweite Hauptfläche sowie zumindest eine Seitenfläche aufweist. Die Seitenfläche verbindet die beiden Hauptflächen miteinander. Beispielsweise verläuft die Seitenfläche senkrecht zu einer Haupterstreckungsrichtung des Konverterelements und kann damit auch quer zu den beiden Hauptflächen verlaufen. Die Seitenfläche begrenzt also das Konverterelement seitlich.

Zum Beispiel ist die erste Hauptfläche der Teil der Außenflächen des Konverterelements, die der Strahlungsauskoppelfläche des strahlungsemittierenden Halbleiterchips im befestigten Zustand zugewandt ist. Zum Beispiel ist die erste Hauptfläche des Konverterelements eine Befestigungsfläche, die zur Befestigung des Konversionsbauteils auf oder an der Strahlungsauskoppelfläche des strahlungsemittierenden Halbleiterchips dienen kann.

Gemäß zumindest einer Ausführungsform enthält das Konverterelement zumindest ein Lumineszenzkonversionsmaterial, das zur Absorption von elektromagnetischer Strahlung eines Wellenlängenbereichs und zur Reemission der absorbierten elektromagnetischen Strahlung in einem anderen Wellenlängenbereich mit größeren Wellenlängen als die absorbierte Strahlung geeignet ist. Beispielsweise wandelt das Lumineszenzkonversionsmaterial über die erste Hauptfläche des Konverterelements in das Konverterelement eintretendes blaues Licht teilweise in gelbes Licht um, das sich dann zusammen mit dem blauen Licht zu weißem Licht, vermischen kann.

Gemäß zumindest einer Ausführungsform umfasst das Konversionsbauteil eine reflektierende Beschichtung, die dazu eingerichtet ist, aus dem Konverterelement austretende elektromagnetische Strahlung zu reflektieren und zumindest teilweise in das Konverterelement zurück zu reflektieren. "Reflektierend" heißt in diesem Zusammenhang, dass die Beschichtung aus dem Konverterelement austretende und auf sie auftreffende elektromagnetische Strahlung zumindest zu 70 %, bevorzugt zu mehr als 80 %, reflektiert.

Gemäß zumindest einer Ausführungsform des Konversionsbauteils bedeckt die reflektierende Beschichtung das Konverterelement an der zumindest einen Seitenfläche zumindest stellenweise. "Zumindest stellenweise" kann dabei bedeuten, dass die reflektierende Beschichtung die Seitenfläche des Konverterelements nur an vorgebbaren Stellen vollständig bedeckt und an anderen Stellen nur bis zu einer gewissen Höhe und/oder gar nicht bedeckt. Mit anderen Worten kann das Konverterelement an manchen Stellen teilweise noch aus der reflektierenden Beschichtung hervorragen und an anderen Stellen vollständig von der reflektierenden Beschichtung verdeckt sein. Weiter kann die reflektierende Beschichtung die zumindest eine Seitenfläche vollständig bedecken. Beispielsweise ist an den bedeckten Stellen des Konverterelements die Seitenfläche mit der reflektierenden Beschichtung in direktem Kontakt. Mit anderen Worten bildet sich vorzugsweise zwischen der reflektierenden Beschichtung und der Seitenfläche des Konverterelements weder ein Spalt noch eine Unterbrechung aus. Dabei ist es insbesondere möglich, dass die reflektierende Beschichtung mit der Seitenfläche des Konverterelements bündig abschließt.

Gemäß zumindest einer Ausführungsform des Konversionsbauteils sind die beiden Hauptflächen des Konverterelements zumindest stellenweise frei von der reflektierenden Beschichtung. "Frei" heißt in diesem Zusammenhang, dass die erste und/oder die zweite Hauptfläche jeweils zumindest einen Flächenbereich aufweisen, der nicht von der reflektierenden Beschichtung bedeckt ist und die reflektierende Beschichtung diesen Flächenbereichen in vertikaler Richtung nicht nachgeordnet ist. "Vertikale Richtung" ist dabei eine Richtung senkrecht zur Haupterstreckungsrichtung des Konverterelements. Über diese Flächenbereiche, beispielsweise die gesamte Fläche der ersten und der zweiten Hauptfläche, kann dann ungehindert elektromagnetische Strahlung in das Konverterelement ein- oder auskoppeln.

Gemäß zumindest einer Ausführungsform des Konversionsbauteils, welches zum Nachordnen an einer Strahlungsauskoppelfläche eines strahlungsemittierenden Halbleiterchips geeignet ist, weist dieses zumindest ein Konverterelement auf, das eine erste Hauptfläche, eine der ersten Hauptfläche gegenüberliegende zweite Hauptfläche sowie zumindest eine Seitenfläche aufweist. Die Seitenfläche verbindet die beiden Hauptflächen miteinander. Weiter enthält das Konverterelement zumindest ein Lumineszenzkonversionsmaterial, das zur Absorption von elektromagnetischer Strahlung eines Wellenlängenbereichs und zur Emission der absorbierten elektromagnetischen Strahlung in einem anderen Wellenlängenbereich geeignet ist. Weiter umfasst das Konversionsbauteil eine reflektierende Beschichtung, die dazu eingerichtet ist, aus dem Konverterelement austretende elektromagnetische Strahlung zu reflektieren und zumindest teilweise in das Konverterelement zurück zu reflektieren. Die reflektierende Beschichtung bedeckt zumindest stellenweise das Konverterelement an der zumindest einen Seitenfläche vollständig, wobei die beiden Hauptflächen des Konverterelements zumindest stellenweise frei von der reflektierenden Beschichtung sind.

"Zum Nachordnen" bedeutet im vorliegenden Zusammenhang insbesondere, dass das Konversionsbauteil selbsttragend ausgebildet und vorgefertigt ist. Mit anderen Worten ist das Konversionsbauteil ein eigenständiges Bauelement, das unabhängig vom Halbleiterchip, dem es nachgeordnet werden soll, gefertigt ist. Insbesondere die reflektierende Beschichtung des Konversionsbauteils wird unabhängig von einer möglicherweise vorhanden reflektierenden Beschichtung des Halbleiterchips erzeugt.

Das hier beschriebene Konversionsbauteil beruht dabei unter anderem auf der Erkenntnis, dass ein Austreten von zumindest teilweise innerhalb eines Konverterelements konvertierter elektromagnetischer Strahlung über Seitenflächen des Konverterelements, statt über eine Hauptfläche des Konverterelements, zu unerwünschten Farbortinhomogenitäten und/oder -verschiebungen der aus dem Konverterelement austretenden elektromagnetischen Strahlung führen kann, falls die gesamte aus dem Konverterelement austretende Strahlung nutzbar gemacht werden soll. Im Wesentlichen können solche Farbortinhomogenitäten darauf zurückgeführt werden, dass aus den Seitenflächen austretende elektromagnetische Strahlung bis zur Auskopplung aus dem Konverterelement eine geringere Wegstrecke innerhalb des Konverterelements zurücklegt, als elektromagnetische Strahlung, die über die Hauptfläche des Konverterelements auskoppelt. Mit anderen Worten, kann die aus der Seitenfläche austretende, unerwünschte elektromagnetische Strahlung einen anderen Farbkonversionsgrad und damit Farbort aufweisen als die über die Hauptfläche ausgekoppelte, erwünschte, elektromagnetische Strahlung. Wird nun, beispielsweise über seitlich von dem Konverterelement angeordnete reflektive Optiken neben der aus der Hauptfläche austretenden ebenso die aus den Seitenflächen des Konverterelements austretende elektromagnetische Strahlung nutzbar gemacht, können sich durch diese reflektiven Optiken die über die Seitenfläche und über die Hauptfläche des Konverterelements austretende elektromagnetische Strahlung miteinander mischen, wodurch sich der Farbort der insgesamt aus dem Konverterelement ausgetretenen elektromagnetischen Strahlung verschieben kann.

Zudem kann es zu Auskoppelverlusten bei Halbleiterbauteilen, die ein solches Konverterelements aufweisen, kommen, da die über die Seitenfläche aus dem Konverterelement austretende elektromagnetische Strahlung beispielweise auf einen seitlich vom Konverterelement angeordneten Gehäusekörper trifft und von diesem absorbiert werden kann.
Die Funktionsweise eines hier beschriebenen Konversionsbauteils ist gemäß zumindest einer Ausführungsform wie folgt:
Zumindest ein Teil der in das Konverterelement eingekoppelten Strahlung wird innerhalb des Konverterelements, durch das im Konverterelement enthaltene Lumineszenzkonversionsmaterial, richtungsunabhängig strahlungskonvertiert und dann von diesem reemittiert. "Richtungsunabhängig" bedeutet, dass die im Konverterelement konvertierte elektromagnetische Strahlung innerhalb des Konverterelements von dem Lumineszenzkonversionsmaterial in keine Vorzugsrichtung reemittiert wird.

Nach der Konversion der elektromagnetischen Strahlung innerhalb des Konverterelements wird ein Teil der konvertierten Strahlung in Richtung der Seitenflächen des Konverterelements reemittiert und tritt dann über die Seitenflächen des Konverterelements aus dem Konverterelement aus. Dieser Strahlungsanteil trifft anschließend zumindest teilweise auf die reflektierende Beschichtung, die dazu eingerichtet ist, aus dem Konverterelement austretende elektromagnetische Strahlung zu reflektieren und zumindest teilweise in das Konverterelement zurück zu reflektieren. Zumindest ein Teil dieser in das Konverterelement zurückreflektierten Strahlung wird in Richtung weg von der ersten Hauptfläche geführt und kann dann aus dem Konverterelement über die zweite Hauptfläche und damit aus dem Konversionsbauteil ausgekoppelt werden. Wird ein Teil der in das Konverterelement zurückreflektierten Strahlung, beispielsweise in Richtung der ersten Hauptfläche zurückreflektiert, kann sich der Reflexionsprozess mehrfach wiederholen. Denkbar ist, dass sich der Reflexionsprozess solange wiederholt, bis der entsprechende Strahlungsanteil aus dem Konverterelement und damit aus dem Konversionsbauteil auskoppelt. Mit anderen Worten setzt sich die aus dem Konverterelement ausgekoppelte elektromagnetische Strahlung aus dem direkten Strahlungsanteil, also dem Strahlungsanteil, der ohne vorherige Reflexion an der reflektierenden Beschichtung aus dem Konverterelement ausgekoppelt wird, und dem Strahlungsanteil, der durch zumindest einmalige (Rück-) Reflexion an der reflektierenden Beschichtung in das Konverterelement zurückreflektiert wird, zusammen und wird durch die zweite Hauptfläche des Konverterelements aus dem Konversionsbauteil ausgekoppelt.

Vorteilhaft wird mittels der hier beschriebenen reflektierenden Beschichtung unter anderem ein Farbort entlang der zweiten Hauptfläche des Konverterelements homogenisiert. Beispielsweise sind mittels des hier beschriebenen Konversionsbauteils Halbleiterbauteile möglich, bei denen auf aufwändige, beispielsweise seitlich von dem Konversionsbauteil angeordnete reflektive Optiken, die die aus den Seitenflächen des Konverterelements austretende elektromagnetische Strahlung in Richtung hin zur zweiten Hauptfläche reflektieren, verzichtet ist. Solche Halbleiterbauteile können besonders kompakt und einfach im Aufbau sein.

Gemäß zumindest einer Ausführungsform überragt die reflektierende Beschichtung das Konverterelement seitlich nicht. Denkbar ist, dass die reflektierende Beschichtung in vertikaler Richtung sowohl mit der ersten als auch mit der zweiten Hauptfläche des Konverterelements bündig abschließt.
Die reflektierende Beschichtung umhüllt dann die Seitenflächen des Konverterelements zum Beispiel vollständig, wodurch der von der reflektierenden Beschichtung in das Konverterelement zurückreflektierte Strahlungsanteil möglichst groß ist. Elektromagnetische Strahlung kann nur an den dafür vorgesehenen Stellen, das heißt ausschließlich über die erste Hauptfläche in das Konverterelement einkoppeln, durch das Konverterelement hindurch treten und es wieder über die zweite Hauptfläche verlassen. Daher trägt die reflektierende Beschichtung zu einer besonders effektiven Konvertierung von elektromagnetischer Strahlung bei.

Gemäß zumindest einer Ausführungsform ist das Konverterelement mit einem keramischen Material gebildet. Dazu kann das Lumineszenzkonversionsmaterial in ein Matrixmaterial, beispielsweise eine Glaskeramik oder eine Keramik, eingebettet sein. Zum Beispiel ist das Konverterelement dann in Form eines Plättchens ausgeführt. Ebenso ist es möglich, dass das Konverterelement vollständig aus einem keramischen Lumineszenzkonversionsmaterial besteht. Das Konverterelement kann dann ein Plättchen aus einem solchen keramischen Lumineszenzkonversionsmaterial sein.

Gemäß zumindest einer Ausführungsform weist die reflektierende Beschichtung ein Grundmaterial auf, welches mit zumindest einem der Materialien keramisches Material, glashaltiges Material, organisches Material, Kunststoffmaterial, Halbleitermaterial gebildet ist.

Gemäß zumindest einer Ausführungsform sind in das Grundmaterial strahlungsreflektierende Partikel eingebracht, wobei ein optischer Brechungsindex der strahlungsreflektierenden Partikel größer als ein optischer Brechungsindex des Grundmaterials ist. Beispielsweise ist der optische Brechungsindex der strahlungsreflektierenden Partikel wenigstens 1,8. Ein derartiger Brechungsindexbereich der strahlungsreflektierenden Partikel hat sich als besonders vorteilhaft im Hinblick auf die strahlungsreflektierenden Eigenschaften der reflektierenden Beschichtung erwiesen.

Gemäß zumindest einer Ausführungsform sind die strahlungsreflektierenden Partikel mit zumindest einem der Materialien TiO₂, ZrO₂, ZnO, Al₂O₃, BaSO₄, MgO, Ta₂O₅, HfO₂, Gd₂O₃, Nb₂O₃, Y₂O₃ gebildet oder enthalten zumindest eines der Materialien. Derartige Partikel haben sich als ganz besonders geeignet erwiesen, um auf sie auftreffende elektromagnetische Strahlung zu reflektieren.

Gemäß zumindest einer Ausführungsform ist die Konzentration der strahlungsreflektierenden Partikel im Grundmaterial wenigstens 10 Vol-%. Beispielsweise sind die strahlungsreflektierenden Partikel innerhalb des Grundmaterials gleichmäßig verteilt. Zum Beispiel erscheint für einen externen Betrachter die reflektierende Beschichtung aufgrund der Reflexionseigenschaften der reflektierenden Beschichtung weiß, da von der reflektierenden Beschichtung vorzugsweise das gesamte auftreffende Farbspektrum des Umgebungslichts reflektiert wird. Es ist jedoch ebenso möglich, dass die reflektierende Beschichtung für einen externen Betrachter andersfarbig erscheint. Die reflektierende Beschichtung weist eine Dicke von wenigstens 50 µm bis höchstens 300 µm auf. "Dicke" ist eine maximale Ausdehnung der reflektierenden Beschichtung beispielsweise in einer Richtung senkrecht zu den Seitenflächen des Konverterelements.

Gemäß zumindest einer Ausführungsform ist die reflektierende Beschichtung mit einem metallischen Material gebildet. Beispielsweise handelt es sich bei dem metallischen Material um Ag und/oder Al. Vorteilhaft ist eine derartige reflektierende Beschichtung für auf sie auftreffende, das heißt aus dem Konverterelement austretende elektromagnetische Strahlung, strahlungsundurchlässig. In diesem Fall weist die reflektierende Beschichtung eine Dicke von wenigstens 100 nm bis höchstens 1 µm auf.

Gemäß zumindest einer Ausführungsform ist die reflektierende Beschichtung mit zumindest einem photonischen Kristall gebildet, wobei der photonische Kristall mit zumindest einer ein-, zwei- und/oder dreidimensionalen photonischen Bandlückenstruktur gebildet ist. "Eindimensional" kann heißen, dass der photonische Kristall in Form einer Schicht ausgebildet ist (auch 1D layer structure). "Zweidimensional" kann heißen, dass der photonische Kristall in Form von Röhren oder Stäbchen ausgebildet sein kann (auch 2D rod structure). Entsprechend kann "dreidimensional" heißen, dass der photonische Kristall mit sphärischen Strukturen gebildet ist (auch 3D sphere structure). Zum Beispiel ist der photonische Kristall mit zumindest zwei beispielsweise im Hinblick auf ihren jeweiligen optischen Reflexionskoeffizienten unterschiedlichen Materialien gebildet. Dabei können die zumindest zwei unterschiedlichen Materialien entlang einer vorgebbaren (Vorzugs)-Richtung periodisch abwechselnd und nacheinander angeordnet. Die Bandlückenposition des photonischen Kristalls kann von der durch die unterschiedlichen Materialien gebildeten Gitterkonstante des photonischen Kristalls abhängen, wobei die Größe der Bandlücke des photonischen Kristalls durch ein Verhältnis der Reflexionskoeffizienten der beiden unterschiedlichen, periodisch angeordneten Materialien bestimmt sein kann. Mit anderen Worten kann mittels des photonischen Kristalls und der darin verwendeten unterschiedlichen Materialien das Reflexionsvermögen angepasst werden.
Gemäß zumindest einer Ausführungsform des Konversionsbauteils umfasst der photonische Kristall Poren, wobei der photonische Kristall mit einem keramischen Material und/oder einem glashaltigen Material gebildet ist. Beispielsweise ist ein derartiger photonischer Kristall durch zumindest eine dreidimensionale photonische Bandlückenstruktur gebildet. Die Poren sind beispielsweise vollständig von dem keramischen und/oder glashaltigen Material umschlossen und zum Beispiel mit Luft gefüllt. Beispielsweise ist das keramische Material mit zumindest einem der Materialien SiO₂, TiO₂ oder einer Mischung aus SiO₂ und TiO₂ gebildet.

Gemäß der Erfindung ist auf zumindest eine dem Konverterelement abgewandte Außenfläche der reflektierenden Beschichtung zumindest stellenweise eine strahlungsabsorbierende Beschichtung aufgebracht. Vorteilhaft kann elektromagnetische Reststrahlung, welche durch die reflektierende Beschichtung hindurch tritt, durch die auf der Außenfläche der reflektierenden Beschichtung aufgebrachte strahlungsabsorbierende Beschichtung absorbiert werden. Zum Beispiel ist dazu die strahlungsabsorbierende Beschichtung mit einem Silikon, einem Epoxid oder einer Mischung aus Silikon oder Epoxid gebildet, in das strahlungsabsorbierende Materialien, beispielsweise Rußpartikel oder andere Füllstoffe, eingebracht sind. Die strahlungsabsorbierende Beschichtung kann dann für einen externen Betrachter schwarz oder farbig erscheinen.

Es wird darüber hinaus ein Halbleiterbauelement angegeben.

Gemäß zumindest einer Ausführungsform umfasst das Halbleiterbauelement zumindest ein Konversionsbauteil, wie es in einer oder mehreren der hier beschriebenen Ausführungsformen beschrieben ist. Das heißt, die für das hier beschriebene Konversionsbauteil aufgeführten Merkmale sind auch für das hier beschriebene Halbleiterbauelement offenbart.

Gemäß zumindest einer Ausführungsform umfasst das Halbleiterbauelement zumindest einen strahlungsemittierenden Halbleiterchip mit einer Strahlungsauskoppelfläche, durch die zumindest ein Teil der im Halbleiterchip erzeugten elektromagnetischen Strahlung den Halbleiterchip verlässt. Bei dem strahlungsemittierenden Halbleiterchip kann es sich beispielsweise um einen Lumineszenzdiodenchip handeln. Bei dem Lumineszenzdiodenchip kann es sich um einen Leucht- oder Laserdiodenchip handeln, der Strahlung im Bereich von Licht im sichtbaren oder ultravioletten Bereich des Spektrums der elektromagnetischen Strahlung emittiert.

Gemäß zumindest einer Ausführungsform ist das Konversionsbauteil zur Konversion von vom Halbleiterchip emittierter elektromagnetischer Strahlung dem Halbleiterchip in seiner Hauptabstrahlrichtung an der Strahlungsauskoppelfläche nachgeordnet. Beispielsweise liegen sich die Strahlungsauskoppelfläche und die erste Hauptfläche des Konverterelements des Konversionsbauteils gegenüber. Beispielsweise ist das Konversionsbauteil mit seiner ersten Hauptfläche auf die Strahlungsauskoppelfläche des strahlungsemittierenden Halbleiterchips direkt aufgebracht und beispielsweise auf die Strahlungsauskoppelfläche mit der ersten Hauptfläche aufgeklebt.

Gemäß zumindest einer Ausführungsform ist zumindest eine Seitenfläche des Halbleiterchips und/oder zumindest eine dem Halbleiterchip abgewandte Außenfläche der reflektierenden Beschichtung von einer weiteren reflektierenden Beschichtung bedeckt. Dabei kann die weitere reflektierende Beschichtung mit den gleichen oder unterschiedlichen Materialien wie die reflektierende Beschichtung gebildet sein. Ist zumindest eine Seitenfläche des Halbleiterchips von der reflektierenden Beschichtung bedeckt, kann vorteilhaft auch aus dem Halbleiterchip und seiner Seitenfläche austretende elektromagnetische Strahlung in Richtung des Konversionsbauteils reflektiert und damit geführt werden. Vorteilhaft wird somit ein möglichst großer Anteil der primär innerhalb des strahlungsemittierenden Halbleiterchips erzeugten elektromagnetischen Strahlung in das Konverterelement des Konversionsbauteils eingekoppelt und anschließend aus dem Halbleiterbauelement ausgekoppelt.

Gemäß zumindest einer Ausführungsform grenzen die reflektierende Beschichtung und die weitere reflektierende Beschichtung direkt aneinander an. Das heißt, dass vorzugsweise zwischen der reflektierenden Beschichtung und der weiteren reflektierenden Beschichtung sich weder ein Spalt noch eine Unterbrechung ausbildet. Sowohl die reflektierende Beschichtung als auch die weitere reflektierende Beschichtung können beispielsweise mittels Sprayen, Dispensen, Elektrophorese oder Druckens auf die jeweiligen Seitenflächen des Konverterelements und des Halbleiterchips aufgebracht werden.

Gemäß zumindest einer Ausführungsform umfasst das Halbleiterbauelement zumindest zwei in lateraler Richtung nebeneinander angeordnete strahlungsemittierende Halbleiterchips, wobei einem jedem Halbleiterchip zur Konversion von vom Halbleiterchip emittierter elektromagnetischer Strahlung dem Halbleiterchip in seiner Hauptabstrahlrichtung an der Strahlungsauskoppelfläche ein Konversionsbauteil nachgeordnet ist. Beispielsweise ist jedem Halbleiterchip genau ein Konverterelement zugeordnet. Dabei ist es möglich, dass jedem Halbleiterchip ein Konverterelement eindeutig zugeordnet ist. Zum Beispiel sind die Halbleiterchips auf einer Oberfläche eines gemeinsamen Trägers aufgebracht. "Laterale Richtung" kann in diesem Zusammenhang eine Richtung quer zur Haupterstreckungsrichtung des Trägers heißen. Beispielsweise sind dann zwischen jeweils benachbarten Halbleiterchips Zwischenräume ausgebildet. Mit anderen Worten sind die Halbleiterchips dann beabstandet zueinander angeordnet. In einer Draufsicht auf das Halbleiterbauteil sind die Zwischenräume durch die Seitenflächen zweier jeweils aneinander angrenzender Halbleiterchips und der den Halbleiterchips zugewandten Oberfläche des Trägers begrenzt. Sind nun die jeweiligen Seitenflächen der Konverterelemente von der reflektierenden Beschichtung bedeckt, kann vorteilhaft vermieden werden, dass von jeweils seitlich, das heißt über die Seitenflächen der Konverterelemente, austretende elektromagnetische Strahlung auf die jeweils benachbarten Konverterelemente und/oder Halbleiterchips trifft und diese beispielsweise im Hinblick auf ihre physikalischen Eigenschaften beeinflusst und/oder beschädigt. Mit anderen Worten kann mittels des hier beschriebenen Konversionsbauteils eine gegenseitige Beeinflussung (auch cross talk) von beispielsweise benachbart angeordneten Konverterelementen und/oder Halbleiterchips vermieden werden. Ein derartiges Halbleiterbauelement kann daher insbesondere für Projektoren, als Hintergrundbeleuchtungen für Bild und Fernsehschirme sowie für Fahrzeugscheinwerfer geeignet sein.

Im Folgenden wird das hier beschriebene Konversionsbauteil sowie das hier beschriebene Halbleiterbauelement anhand von Ausführungsbeispielen und den dazugehörigen Figuren näher erläutert.

Die Figuren 1A bis 1D zeigen in schematischen Ansichten Ausführungsbeispiele eines hier beschriebenen Konversionsbauteils.

Die Figuren 2A bis 2B zeigen Ausführungsbeispiele eines hier beschriebenen Halbleiterbauelements.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

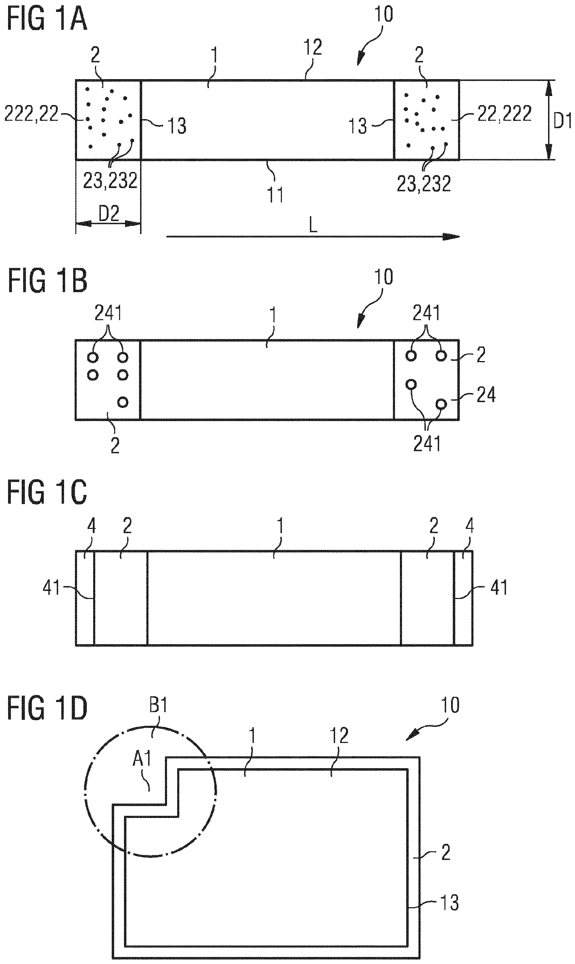

In der Figur 1A ist anhand einer schematischen Schnittdarstellung ein hier beschriebenes Konversionsbauteil 10 mit einem Konverterelement 1 dargestellt. Das Konverterelement 1 weist eine erste Hauptfläche 11, eine der ersten Hauptfläche 11 gegenüberliegende zweite Hauptfläche 12 sowie Seitenflächen 13 auf, wobei die Hauptflächen 11 und 12 parallel einer lateralen Richtung L verlaufen. Die Seitenflächen 13 verbinden die beiden Hauptflächen 11 und 12 miteinander, wobei die Seitenflächen 13 senkrecht zur lateralen Richtung L, und ebenso senkrecht zu den beiden Hauptflächen 11 und 12 verlaufen. Das Konverterelement 1 kann zumindest ein Lumineszenzkonversionsmaterial enthalten. Das Lumineszenzkonversionsmaterial absorbiert in das Konverterelement 1 eingekoppelte elektromagnetische Strahlung eines Wellenbereichs zumindest teilweise und reemittiert die absorbierte elektromagnetische Strahlung in einem anderen Wellenlängenbereich richtungsunabhängig. Das heißt, das Lumineszenzkonversionsmaterial reemittiert die konvertierte elektromagnetische Strahlung sowohl in Richtung der beiden Hauptflächen 11 und 12 als auch in Richtung der Seitenflächen 13 ohne einer Vorzugsrichtung. Zum Beispiel ist das Konverterelement 1 mit einem keramischen Material gebildet, in das das Lumineszenzkonversionsmaterial eingebracht ist. Dazu kann das Lumineszenzkonversionsmaterial in ein Matrixmaterial, beispielsweise eine Glaskeramik oder eine Keramik, eingebettet sein. Ebenso ist es möglich, dass das Konverterelement vollständig aus einem keramischen Lumineszenzkonversionsmaterial besteht. Bei dem keramischen Lumineszenzkonversionsmaterial kann es sich insbesondere um YAG:Ce handeln.

Eine reflektierende Beschichtung 2 bedeckt die Seitenflächen 13 vollständig und reflektiert aus dem Konverterelement 1 über die Seitenflächen 13 austretende elektromagnetische Strahlung zurück in das Konverterelement 1. Beispielsweise ist die reflektierende Beschichtung 2 mit einem organischen oder glashaltigen Grundmaterial 22 gebildet, in das strahlungsreflektierende Partikel 23 eingebracht sind. Die strahlungsreflektierenden Partikel 23 weisen einen optischen Brechungsindex 232 auf, der größer als ein optischer Brechungsindex 222 des Grundmaterials ist. Zum Beispiel sind die strahlungsreflektierenden Partikel 23 mit zumindest einem der Materialien TiO₂, ZrO₂, ZnO, Al₂O₃, BaSO₄, MgO, Ta₂O₅, HfO₂, Gd₂O₃, Nb₂O₃, Y₂O₃ gebildet oder enthalten zumindest eines dieser Materialien. Beispielsweise weisen die strahlungsreflektierenden Partikel einen d₅₀-Wert, in Q₀ gemessen, von wenigstens 100 nm bis höchstens 300 nm, beispielsweise 200 nm, auf. Ein derartiger Größenbereich der strahlungsreflektierenden Partikel 23 hat sich insbesondere für eine besonders effektive Reflexion von elektromagnetischer Strahlung bei einer Wellenlänge von 500 nm erwiesen. Weiter weisen die strahlungsreflektierenden Partikel 23 eine Konzentration im Grundmaterial 22 von wenigstens 20 Gew-% auf. Vorteilhaft kann das Reflexionsvermögen der reflektierenden Beschichtung 2 in Abhängigkeit der Konzentration der strahlungsreflektierenden Partikel 23 individuell eingestellt werden. Vorliegend erscheint für einen externen Betrachter die reflektierende Beschichtung 2 aufgrund der Reflexionseigenschaften weiß, da von der reflektierenden Beschichtung 2 vorzugsweise das gesamte Auftreffen des Farbspektrums reflektiert wird.

Die beiden Hauptflächen 11 und 12 des Konverterelements 1 sind vollständig frei von der reflektierenden Beschichtung 2, wobei die reflektierende Beschichtung 2 das Konverterelement 1 seitlich nicht überragt. Insbesondere kann eine Dicke D2 der reflektierenden Beschichtung 2 wenigstens eine Dicke D1 des Konverterelements 1 betragen.

Die Figur 1B zeigt in einer schematischen Seitenansicht ein weiteres Ausführungsbeispiel eines hier beschriebenen Konversionsbauteils 10.

Im Unterschied zu dem in der Figur 1A gezeigten Konversionsbauteil 10 ist die reflektierende Beschichtung 2 mit einem photonischen Kristall 24 gebildet, wobei der photonische Kristall 24 mit einer dreidimensionalen photonischen Bandlückenstruktur gebildet ist. Der photonische Kristall 24 umfasst Poren 241, die mit Luft gefüllt sind. Dabei ist der photonische Kristall 24 mit einem keramischen Material, beispielsweise TiO₂ und/oder SiO₂ gebildet. Die hier beschriebene reflektierende Beschichtung 2 weist eine besonders hohe Reflektivität auf. Ist der photonische Kristall 24 zum Beispiel mit TiO₂ gebildet, kann eine vollständige Reflexion in allen drei Raumrichtungen der auf die reflektierende Beschichtung 2 auftreffenden elektromagnetischen Strahlung erreicht werden. Insbesondere können die Poren 241 einen Durchmesser, das heißt einen maximalen Abstand zweier Punkte innerhalb einer Pore 241, von wenigstens 200 nm und höchstens 300 nm, beispielsweise von 250 nm, aufweisen. Eine derartige Porengröße der Poren 241 kann insbesondere zur effizienten Reflexion von elektromagnetischer Strahlung bei einer Wellenlänge von beispielsweise 500 nm dienen.

In der Figur 1C ist in einer schematischen Seitenansicht ein weiteres Ausführungsbeispiel eines hier beschriebenen Konversionsbauteils 10 gemäß der Erfindung gezeigt, wobei im Unterschied zu den in den Figuren 1A und 1B gezeigten Konversionsbauteilen 10 zusätzlich auf eine dem Konverterelement 1 abgewandte Außenfläche 41 der reflektierenden Beschichtung 2 vollständig eine strahlungsabsorbierende Beschichtung 4 aufgebracht ist. Beispielsweise ist die strahlungsabsorbierende Beschichtung 4 mit einem Matrixmaterial gebildet, in das strahlungsabsorbierende Partikel oder Fasern eingebracht sind. Beispielsweise handelt es sich bei den strahlungsabsorbierenden Partikeln um Rußpartikel oder Partikel, die mit Fe₃O₄ gebildet sind. Die strahlungsabsorbierende Beschichtung 4 kann für einen externen Betrachter schwarz erscheinen. Vorteilhaft kann durch die reflektierende Beschichtung 2 hindurch tretende elektromagnetische Strahlung von der strahlungsabsorbierenden Beschichtung 4 absorbiert werden. Zudem kann dadurch vermieden werden, dass unerwünschte Reststrahlung das Konverterelement 1 durch die Seitenflächen 13 verlässt.
In der Figur 1D ist in einer schematischen Draufsicht ein hier beschriebenes Konversionsbauteil 10, beispielsweise gemäß zumindest einer, der wie in den Figuren 1A bis 1C beschriebenen Ausführungsformen, dargestellt. Erkennbar ist die zweite Hauptfläche 12 des Konverterelements 1 sowie die reflektierende Beschichtung 2. Die reflektierende Beschichtung 2 ist vollständig auf alle sechs Seitenflächen 13 vollständig aufgebracht. Ferner weist das Konverterelement 1 in einem Bereich B1 eine Aussparung A1 auf. Durch die Aussparung A1 kann, für den Fall, dass das Konversionsbauteil 10 auf einer Strahlungsauskoppelfläche eines strahlungsemittierenden Halbleiterchips aufgebracht ist, ein Bonddrahtanschlussbereich des Halbleiterchips freigelegt sein.

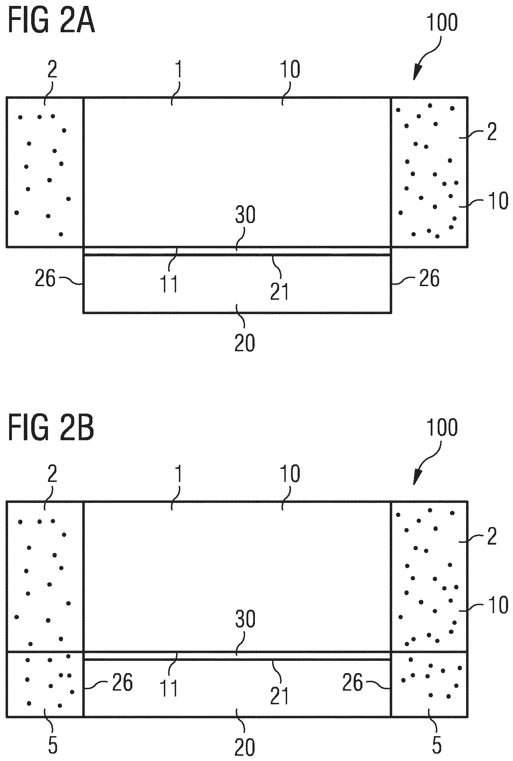

Die Figuren 2A und 2B zeigen in schematischen Seitenansichten Ausführungsbeispiele eines hier beschriebenen Halbleiterbauelements 100.

In der Figur 2A ist ein strahlungsemittierender Halbleiterchip 20 mit einer Strahlungsauskoppelfläche 21, durch die zumindest ein Teil der im Halbleiterchip 20 erzeugten elektromagnetischen Strahlung den Halbleiterchip 20 verlässt, dargestellt. Zwischen der Strahlungsauskoppelfläche 21 und der ersten Hauptfläche 11 des Konverterelements 1 ist eine Anhaftschicht 30 angeordnet. Die Anhaftschicht 30 steht über die Strahlungsauskoppelfläche 21 und die erste Hauptfläche 11 sowohl mit dem Konverterelement 1 als auch mit Halbleiterchip 20 in direktem Kontakt, sodass sich zwischen der Anhaftschicht 30 einerseits und dem Konverterelement 1 sowie dem Halbleiterchip 20 andererseits weder ein Spalt noch eine Unterbrechung ausbildet. Die Anhaftschicht 30 ermöglicht eine mechanisch feste Verbindung zwischen dem Halbleiterchip 20 und dem Konversionsbauteil 10. Beispielsweise ist die Anhaftschicht 30 mit einem Silikon gebildet. Vorzugsweise ist die Anhaftschicht 30 für vom Halbleiterchip 20 emittierte elektromagnetische Strahlung durchlässig. Dabei sind alle Seitenflächen 26 frei von der reflektierenden Beschichtung 2.

In der Figur 2B ist im Unterschied zu dem in der Figur 2A gezeigten Ausführungsbeispiel auf die Seitenflächen 26 des Halbleiterchips 20 vollständig eine weitere reflektierende Beschichtung 5 aufgebracht. Die weitere reflektierende Beschichtung 5 und die reflektierende Beschichtung 2 grenzen direkt aneinander. Die beiden Beschichtungen 2 und 5 mit dem jeweils gleichen Material oder mit jeweils unterschiedlichen Materialien gebildet sein.

Die Erfindung ist nicht durch die Beschreibung anhand der Ausführungsbeispiele beschränkt. Vielmehr umfasst die Erfindung jedes neue Merkmal sowie die Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder den Ausführungsbeispielen angegeben ist.
Diese Patentanmeldung beansprucht die Priorität der deutschen Patentanmeldung 102010048162. 9.

## Patentansprüche

1. Konversionsbauteil (10), zum Nachordnen an einer Strahlungsauskoppelfläche eines strahlungsemittierenden Halbleiterchips, mit
- einem Konverterelement (1), das eine erste Hauptfläche (11), eine der ersten Hauptfläche (11) gegenüberliegende zweite Hauptfläche (12) sowie zumindest eine Seitenfläche (13) aufweist, wobei die Seitenfläche (13) die beiden Hauptflächen (11, 12) miteinander verbindet, und das Konverterelement (1) zumindest ein Lumineszenzkonversionsmaterial enthält, das zur Absorption von elektromagnetischer Strahlung eines Wellenlängenbereichs und zur Reemission der absorbierten elektromagnetischen Strahlung in einem anderen Wellenlängenbereich mit größeren Wellenlängen als die absorbierte Strahlung geeignet ist;
- einer reflektierenden Beschichtung (2), die dazu eingerichtet ist, aus dem Konverterelement (1) austretende elektromagnetische Strahlung zu reflektieren und zumindest teilweise in das Konverterelement (1) zurück zu reflektieren, wobei
- die reflektierende Beschichtung (2) das Konverterelement (1) an der zumindest einen Seitenfläche (13) zumindest stellenweise bedeckt, und
- die beiden Hauptflächen (11, 12) des Konverterelements (1) zumindest stellenweise frei von der reflektierenden Beschichtung (2) sind, und
- wobei das Konversionsbauteil selbsttragend ausgebildet ist,
**dadurch gekennzeichnet, dass** auf zumindest eine dem Konverterelement (1) abgewandte Außenfläche (41) der reflektierenden Beschichtung (2) zumindest stellenweise eine strahlungsabsorbierende Beschichtung (4) aufgebracht ist.

2. Konversionsbauteil (10) nach dem vorhergehenden Anspruch,
bei dem die reflektierende Beschichtung (2) das Konverterelement (1) seitlich nicht überragt.

3. Konversionsbauteil (10) nach Anspruch 1 oder 2,
bei dem das Konverterelement (1) mit einem keramischen Material gebildet ist.

4. Konversionsbauteil (10) nach einem der vorhergehenden Ansprüche,
bei dem die reflektierende Beschichtung (2) ein Grundmaterial (22) aufweist, welches mit zumindest einem der folgenden Materialien gebildet ist: keramisches Material, glashaltiges Material, organisches Material, Kunststoffmaterial, Halbleitermaterial.

5. Konversionsbauteil (10) nach dem vorhergehenden Anspruch,
bei dem in das Grundmaterial (22) strahlungsreflektierende Partikel (23) eingebracht sind, wobei ein optischer Brechungsindex (232) der strahlungsreflektierenden Partikel (23) größer als ein optischer Brechungsindex (222) des Grundmaterials (22) ist.

6. Konversionsbauteil (10) nach dem vorhergehenden Anspruch,
bei dem die strahlungsreflektierenden Partikel (23) mit zumindest einem der folgenden Materialien gebildet sind oder zumindest eines der folgenden Materialien enthalten: TiO₂, ZrO₂, ZnO, Al₂O₃, BaSO₄, MgO, Ta₂O₅, HfO₂, Gd₂O₃, Nb₂O₃, Y₂O₃.

7. Konversionsbauteil (10) nach einem der Ansprüche 5 bis 6,
bei dem die Konzentration der strahlungsreflektierenden Partikel (23) im Grundmaterial (22) wenigstens 10 Vol-% beträgt.

8. Konversionsbauteil (10) nach einem der vorhergehenden Ansprüche,
bei dem die reflektierende Beschichtung (2) mit einem metallischen Material gebildet ist.

9. Konversionsbauteil (10) nach einem der Ansprüche 1 bis 8,
bei dem die reflektierende Beschichtung (2) mit zumindest einem photonischen Kristall (24) gebildet ist, wobei der photonische Kristall (24) mit zumindest einer ein-, zwei- und/oder dreidimensionalen photonischen Bandlückenstruktur gebildet ist.

10. Konversionsbauteil (10) nach Anspruch 9,
bei dem der photonische Kristall (24) Poren (241) umfasst, wobei der photonische Kristall (24) mit einem keramischen Material und/oder einem glashaltigen Material gebildet ist.

11. Halbleiterbauelement (100), mit
- zumindest einem Konversionsbauteil (10) gemäß zumindest einem der vorhergehenden Ansprüche;
- zumindest einem strahlungsemittierenden Halbleiterchip (20) mit einer Strahlungsauskoppelfläche (21), durch die zumindest ein Teil der im Halbleiterchip (20) erzeugten elektromagnetischen Strahlung den Halbleiterchip (20) verlässt, wobei
- das Konversionsbauteil (10) zur Konversion von vom Halbleiterchip (20) emittierter elektromagnetischer Strahlung dem Halbleiterchip (20) in seiner Hauptabstrahlrichtung an der Strahlungsauskoppelfläche (21) nachgeordnet ist.

12. Halbleiterbauelement (100) nach Anspruch 11,
bei dem zumindest stellenweise zumindest eine Seitenfläche (26) des Halbleiterchips (20) und/oder eine dem Halbleiterchip (20) abgewandte Außenfläche der reflektierenden Beschichtung (2) von einer weiteren reflektierenden Beschichtung (5) bedeckt ist.

13. Halbleiterbauelement (100) nach Anspruch 12,
bei dem die reflektierende Beschichtung (2) und die weitere reflektierende Beschichtung (5) direkt aneinander angrenzen.

## Claims

1. Conversion component (10), for arrangement downstream at a radiation coupling-out surface of a radiation-emitting semiconductor chip, having
- a converter element (1), comprising a first main surface (11), a second main surface (12) opposite the first main surface (11) and at least one side surface (13), wherein the side surface connects the two main surfaces (11, 12) to one another, and the converter element (1) contains at least one luminescence conversion material, which is suitable for absorbing electromagnetic radiation of a wavelength range and re-emitting the absorbed electromagnetic radiation in another wavelength range with larger wavelengths than the absorbed radiation;
- a reflective coating (2), which is formed to reflect electromagnetic radiation exiting from the converter element (1) and to reflect it at least partially back into the converter element (1), wherein
- the reflective coating (2) covers the converter element (1) at least in places at the at least one side surface (13), and
- the two main surfaces (11, 12) of the converter element (1) are free of the reflective coating (2) at least in places
- wherein the conversion component is formed in a self-supporting manner, **characterized in that** a radiation-absorbing coating (4) is applied at least in places to at least one outer surface (41) of the reflective coating (2) remote from the converter element (1).

2. Conversion component (10) according to the preceding claim, in which the reflective coating (2) does not project beyond the converter element (1) at the sides.

3. Conversion component (10) according to claim 1 or claim 2, in which the converter element (1) is formed with a ceramic material.

4. Conversion component (10) according to one of the preceding claims, in which the reflective coating (2) comprises a base material (22), which is formed with at least one of the following materials: ceramic material, vitreous material, organic material, plastics material, semiconductor material.

5. Conversion component (10) according to the preceding claim, in which radiation-reflecting particles (23) are introduced into the base material (22), wherein an optical refractive index (232) of the radiation-reflecting particles (23) is greater than an optical refractive index (222) of the base material (22).

6. Conversion component (10) according to the preceding claim, in which the radiation-reflecting particles (23) are formed with or contain at least one of the following materials: TiO₂, ZrO₂, ZnO, Al₂O₃, BaSO₄, MgO, Ta₂O₅, HfO₂, Gd₂O₃, Nb₂O₃, Y₂O₃.

7. Conversion component (10) according to one of claims 5 to 6, in which the concentration of radiation-reflecting particles (23) in the base material (22) amounts to at least 10 vol.%.

8. Conversion component (10) according to one of the preceding claims, in which the reflective coating (2) is formed with a metallic material.

9. Conversion component (10) according to one of claims 1 to 8, in which the reflective coating (2) is formed with at least one photonic crystal (24), wherein the photonic crystal (24) is formed with at least one one-, two- and/or three-dimensional photonic band gap structure.

10. Conversion component (10) according to claim 9, in which the photonic crystal (24) comprises pores (241), wherein the photonic crystal (24) is formed with a ceramic material and/or a vitreous material.

11. Semiconductor device (100), having
- at least one conversion component (10) according to at least one of the preceding claims;
- at least one radiation-emitting semiconductor chip (20), having a radiation coupling-out surface (21) through which at least some of the electromagnetic radiation generated in the semiconductor chip (20) leaves the semiconductor chip (20), wherein
- the conversion component (10) for conversion of electromagnetic radiation emitted by the semiconductor chip (20) is arranged downstream of the semiconductor chip (20) in its main emission direction at the radiation coupling-out surface (21).

12. Semiconductor device (100) according to claim 11, in which at least one side surface (26) of the semiconductor chip (20) and/or one outer surface of the reflective coating (2) remote from the semiconductor chip (20) is covered by a further reflective coating (5) at least in places.

13. Semiconductor device (100) according to claim 12, in which the reflective coating (2) and the further reflective coating (5) directly adjoin one another.

## Revendications

1. Composant de conversion (10), destiné à être disposé en aval sur une surface de sortie de rayonnement d'une puce à semi-conducteur émettant un rayonnement, comprenant
- un élément convertisseur (1) qui présente une première surface principale (11), une deuxième surface principale (12) opposée à la première surface principale (11) ainsi qu'au moins une surface latérale (13), la surface latérale (13) reliant entre elles les deux surfaces principales (11, 12), et l'élément convertisseur (1) contenant au moins un matériau de conversion de luminescence, lequel est approprié à l'absorption d'un rayonnement électromagnétique d'une plage de longueur d'onde et à la réémission du rayonnement électromagnétique absorbé dans une autre plage de longueur d'onde à longueurs d'onde plus grandes que le rayonnement absorbé;
- un revêtement réfléchissant (2) qui est conçu pour réfléchir le rayonnement électromagnétique sortant de l'élément convertisseur (1) et pour le réfléchir en retour, au moins en partie, dans l'élément convertisseur (1),
- le revêtement réfléchissant (2) recouvrant l'élément convertisseur (1) au moins par endroits sur l'au moins une surface latérale (13), et
- les deux surfaces principales (11, 12) de l'élément convertisseur (1) étant exemptes, au moins par endroits, du revêtement réfléchissant (2), et
- le composant de conversion étant réalisé de manière autoportante,
**caractérisé en ce qu'**un revêtement absorbant (4) le rayonnement est appliqué au moins par endroits sur au moins une surface extérieure (41) du revêtement réfléchissant (2), détournée de l'élément convertisseur (1).

2. Composant de conversion (10) selon la revendication précédente,
dans lequel le revêtement réfléchissant (2) ne fait latéralement pas saillie de l'élément convertisseur (1).

3. Composant de conversion (10) selon la revendication 1 ou 2, dans lequel l'élément convertisseur (1) est formé avec un matériau céramique.

4. Composant de conversion (10) selon l'une quelconque des revendications précédentes,
dans lequel le revêtement réfléchissant (2) présente un matériau de base (22) qui est formé par au moins l'un des matériaux suivants: matériau céramique, matériau contenant du verre, matériau organique, matériau plastique, matériau semi-conducteur.

5. Composant de conversion (10) selon la revendication précédente,
dans lequel des particules réfléchissant (23) le rayonnement sont intégrées dans le matériau de base (22), un indice de réfraction optique (232) des particules réfléchissant (23) le rayonnement étant supérieur à un indice de réfraction (222) optique du matériau de base (22) .

6. Composant de conversion (10) selon la revendication précédente,
dans lequel les particules réfléchissant (23) le rayonnement sont formées avec au moins l'un des matériaux suivants ou contiennent au moins l'un des matériaux suivants: TiO₂, ZrO₂, ZnO, Al₂O₃, BaSO₄, MgO, Ta₂O₅, HfO₂, Gd₂O₃, Nb₂O₃, Y₂O₃.

7. Composant de conversion (10) selon l'une quelconque des revendications 5 à 6,
dans lequel la concentration, dans le matériau de base (22), des particules réfléchissant (23) le rayonnement est au moins de 10% en volume.

8. Composant de conversion (10) selon l'une quelconque des revendications précédentes,
dans lequel le revêtement réfléchissant (2) est formé par un matériau métallique.

9. Composant de conversion (10) selon l'une quelconque des revendications 1 à 8,
dans lequel le revêtement réfléchissant (2) est formé par au moins un cristal photonique (24), le cristal photonique (24) étant formé par au moins une structure à bande interdite photonique unidimensionnelle, bidimensionnelle et/ou tridimensionnelle.

10. Composant de conversion (10) selon la revendication 9, dans lequel le cristal photonique (24) comprend des pores (241), le cristal photonique (24) étant formé par un matériau céramique et/ou par un matériau contenant du verre.

11. Dispositif semi-conducteur (100) comprenant
- au moins un composant de conversion (10) selon au moins l'une des revendications précédentes;
- au moins une puce à semi-conducteur (20) émettant un rayonnement, dotée d'une surface de sortie de rayonnement (21) à travers laquelle au moins une partie du rayonnement électromagnétique généré dans la puce à semi-conducteur (20) sort du puce à semi-conducteur (20),
- le composant de conversion (10), pour la conversion du rayonnement électromagnétique émis par la puce à semi-conducteur (20), étant disposé sur la surface de sortie de rayonnement (21) en aval de la puce à semi-conducteur (20) dans sa direction de rayonnement principal.

12. Dispositif semi-conducteur (100) selon la revendication 11, dans lequel au moins une surface latérale (26) de la puce à semi-conducteur (20) et/ou une surface extérieure du revêtement réfléchissant (2) le rayonnement, détournée de la puce à semi-conducteur (20), étant recouvertes au moins par endroits par un revêtement réfléchissant supplémentaire (5) .

13. Dispositif semi-conducteur (100) selon la revendication 11, dans lequel le revêtement réfléchissant (2) le rayonnement et le revêtement réfléchissant supplémentaire (5) sont directement adjacents l'un à l'autre.
